# EUROPEAN PATENT APPLICATION

(11) **EP 2 320 480 A2**
(43) Date of publication of application: **11.05.2011**
(21) Application number: 10189301.4
(22) Date of filing: 28.10.2010
(51) Int. Cl.: H01L 31/072, H01L 31/0224, H01L 31/20, H01L 31/0376

(54) **Layer for thin film photovoltaics and a solar cell made therefrom**

(30) Priority: 04.11.2009 US 612271
(71) Applicant: General Electric Company, Schenectady, NY 12345 (US)
(72) Inventor: Korevaar, Bastiaan Arie, Niskayuna, NY 12309 (US); Xi, Yangang Andrew, Niskayuna, NY 12309 (US); Ahmad, Faisal Razi, Niskayuna, NY 12309 (US); Johnson James Neil, Niskayuna, NY 12309 (US)
(74) Representative: Bedford, Grant Richard

(57) **Abstract**

A photovoltaic device 100 is provided. The photovoltaic device comprises an absorber layer 116 comprising a p-type semiconductor, wherein at least one layer is disposed over the absorber layer. The at least one layer is a semiconductor having a higher carrier density than the carrier density of the absorber layer. The at least one layer comprises silicon. The at least one layer comprises a p+-type semiconductor. The absorber layer 116 is substantially free of silicon. A method 200 of forming the photovoltaic device 100 is provided.

## Description

The invention relates generally to the field of photovoltaics. In particular, the invention relates to a layer used in a photovoltaic device and a solar panel made therefrom.

Solar energy is abundant in many parts of the world year around. Unfortunately, the available solar energy is not generally used efficiently to produce electricity. The cost of conventional solar cells, and electricity generated by these cells, is generally very high. For example, a typical solar cell achieves a conversion efficiency of less than 20 percent. Moreover, solar cells typically include multiple layers formed on a substrate, and thus solar cell manufacturing typically requires a significant number of processing steps. As a result, the high number of processing steps, layers, interfaces, and complexity increase the amount of time and money required to manufacture these solar cells.

Accordingly, there remains a need for an improved solution to the long-standing problem of inefficient and complicated solar energy conversion devices and methods of manufacture.

In one embodiment of the present invention, a photovoltaic device is provided. The photovoltaic device comprises an absorber layer comprising a p-type semiconductor, wherein at least one layer is disposed over the absorber layer. The at least one layer is a semiconductor having a higher carrier density than the carrier density of the absorber layer. The at least one layer comprises silicon. The at least one layer comprises a p+-type semiconductor. The absorber layer is substantially free of silicon.

Another embodiment is a photovoltaic device. The device comprises an absorber layer, wherein the absorber layer comprises a tellurium-containing II-VI semiconductor. The at least one layer is disposed over the absorber layer. The at least one layer is a p+-type semiconductor, comprising silicon.

Another embodiment is a photovoltaic device. The device comprises an absorber layer, wherein the absorber layer comprises a p-type tellurium-containing II-VI semiconductor. The at least one layer is disposed over the absorber layer. The at least one layer is a p+-type semiconductor, comprising silicon.

Yet another embodiment is a photovoltaic device. The device comprises an absorber layer, wherein the absorber layer comprises a p-type cadmium telluride. At least one layer is disposed over the absorber layer, wherein the at least one layer comprises a p+-type hydrogenated amorphous silicon.

Yet another embodiment is a photovoltaic device. The device comprises an absorber layer, wherein the absorber layer comprises a p-type cadmium telluride. At least one layer is disposed over the absorber layer, wherein the at least one layer comprises a p+-type hydrogenated amorphous-silicon carbon.

Still yet another embodiment is a method. The method comprises a first step of providing an absorber layer in a photovoltaic device. The absorber layer is treated to increase its carrier density. Further, the absorber layer is etched to provide a stoichiometric absorber layer. The absorber layer comprises a p-type semiconductor. The absorber layer is substantially free of silicon. At least one layer is disposed over the absorber layer. The at least one layer is a semiconductor having a higher carrier density than the carrier density of the absorber layer. The at least one layer comprises a p+-type semiconductor. The at least one layer comprises silicon.

Various features, aspects, and advantages of the present invention will become better understood when the following detailed description is read with reference to the accompanying drawings in which like characters represent like parts throughout the drawings, and wherein:
FIG. 1 illustrates a schematic of a photovoltaic device in accordance with one embodiment of the present invention;
FIG. 2 illustrates a flow diagram of a method to make a layer of a photovoltaic device as shown in FIG. 1 in accordance with certain embodiments of the present invention; and
FIG. 3 illustrates a schematic of a method to make a layer of a photovoltaic device as shown in FIG. 1 in accordance with certain embodiments of the present invention.

Cadmium telluride (CdTe) based solar devices known in the art typically demonstrate relatively low power conversion efficiencies, which may be attributed to a relatively low open circuit voltage (*V*_{oc}) in relation to the band gap of the material. Further issues with improving the cell efficiency of CdTe solar cells include the high work function of CdTe. The high work function of CdTe leaves a narrow choice of metals that can be employed to form an Ohmic contact with the CdTe layer. The metals include platinum and gold, which are not commercially viable metals for low-cost mass-production of the CdTe solar cells. However, though other metals like molybdenum, nickel, chromium, etc. may be employed, they form a barrier; for example, in the case of p-type CdTe, the holes will need to tunnel through the barrier region. As CdTe has typical carrier densities between 1 x 10¹⁴ and 1 x 10¹⁵ per cubic centimeter, this barrier may be relatively large. It has been found that without proper treatment of the backside of the CdTe layer, the resistance with the back contact layer is significant and the fill factor of the device is reduced, thus reducing the efficiency of the device. One approach to improve the back-contact resistance includes increasing the carrier concentration in the regions near the contact points of the CdTe layer and the back contact layer, wherein the back contact layer is a metal layer. For example, for a p-type CdTe material increasing the carrier concentration amounts to increasing the p-type carriers in the CdTe material to form a "p+ layer" on the backside of the CdTe layer which is in contact with the back contact layer. As used herein the phrase "carrier density" refers to the concentration of the holes and electrons in a material. As used herein the phrase "higher carrier density" means the concentration of the p-type charge carriers in the at least one layer formed using the p+-layer is higher than the concentration of the p-type charge carriers in the absorber layer. Creating a highly doped area with carrier density of greater than or equal to 1 x 10¹⁷ per cubic centimeter may help in lowering the contact resistance with the back contact layer.

Various methods are known in the art for creating a highly doped area. One method includes treating the backside of the CdTe absorber layer that will be in contact with the back contact layer with copper or gold. The copper atoms or gold atoms replace the cadmium atoms in the crystal lattice creating additional acceptor states near the back contact. Another method includes forming a thin layer of a different phase material, such as for example mercury telluride (HgTe), zinc telluride (ZnTe), copper telluride (CuₓTe), arsenic telluride (As₂Te₃), or antimony telluride (Sb₂Te₃), on the backside of the CdTe layer. Valence band alignment is achieved through the anion rule. One method of forming such a layer includes forming a tellurium-rich layer on the backside of the CdTe layer, using the cadmium chloride (CdC1₂) treatment to increase the carrier density in the CdTe layer. In certain embodiments, a copper layer is deposited on the CdC1₂ treated CdTe layer to form a CuₓTe phase which forms the p+-type layer.

The p⁺-type layers have significant drawbacks. When gold and copper are used, both gold and copper are known to diffuse through the material, over the lifetime of the device, causing significant degradation. HgTe has some environmental concerns due to mercury contamination. Copper tellurium (CuₓTe) and zinc tellurium (ZnTe) provide a maximum charge density limited to maximum 10¹⁸ per cubic centimeter due to the multi-crystalline nature of the films formed. Thus, the p+-layer formed by replacing the cadmium by copper and zinc may not have sufficiently high carrier concentration of holes meaning the concentration of holes may be below 10¹⁸ per cubic centimeter.

An alternative layer and method is provided herein to better overcome the differences in charge densities at the interface of the absorber layer and the at least one layer, providing a material that is compatible with absorber layer materials, such as CdTe. The alternative layer may be used as an interface between the absorber layer and the back contact layer with carrier densities that can equal or exceed the carrier density of 1 x 10¹⁸ per cubic centimeter, needed to minimize the series resistance of the back contact layer, in comparison to other resistances within the device. The method includes employing another layer i.e., the alternative layer, in conjunction with the CdTe layer. The alternative layer is a p+-layer, having a higher carrier density when compared to the carrier density of the absorber layer, the p+ -layer described herein thus has a higher carrier density than can be attained in a typical p+-type material as currently known in the art. In one embodiment, the layer may have a carrier density of holes of greater than about 5x 10¹⁷ per cubic centimeter, as currently used for CdTe type devices. In another embodiment, the layer may have a carrier density of holes of greater than about 10¹⁸ per cubic centimeter. In yet another embodiment, the layer may have a carrier density of holes of greater than about 2x10¹⁸ per cubic centimeter. The higher the carrier density of the layer, the better is the capability of the layer to minimize the gap in work function of the layer and the absorber layer.

Various of the embodiments of the invention described herein address the noted shortcomings of the state of the art. One device includes an absorber layer comprising a p-type semiconductor and at least one layer comprising silicon disposed over the absorber layer. Further, the at least one layer is a p+-type semiconductor having a higher carrier density than the carrier density of the absorber layer. The absorber layer and the p+-layer are compositionally different in that the absorber layer is substantially free of silicon. As used herein, the phrase "substantially free of silicon" refers to a semiconductor material containing up to about 100 parts per million silicon as an impurity. Also, it means that the amount of silicon found is around typical impurity levels of silicon found in CdTe and copper-indium-gallium-selenium (CIGS) type materials. In other words, the phrase "substantially free of silicon" means that silicon is not a main component of the film, though it could occur as a contaminant or a dopant in the absorber layer. For example, trace amounts of silicon may be present in CdTe, which emanates from the silicon-dioxide glass used as the substrate due to the high processing temperatures used for forming the device.

In certain embodiments, the at least one layer also has a larger band gap than the absorber layer. In some embodiments, the layer has a higher work function than the absorber layer. Further, in some embodiments the layer has an electron affinity of less than or equal to the electron affinity of the absorber layer. In one embodiment, the band gap of the at least one layer may be larger or equal to the band gap of the absorber layer to minimize optical absorption in the at least one layer. Absorption in this layer may lead to leakage currents, which will lower the efficiency of the device. In one embodiment, the electron affinity of the at least one layer may be lower than or equal to the electron affinity of the absorber layer to provide a barrier for electrons on the backside of the device, acting as a backside surface field which reduces the electron-hole recombination at the cell's back surface thereby increasing efficiency. In one embodiment, the work function of the at least one layer may be larger or equal to the work function of the absorber layer to minimize any barrier for the holes, as they are collected at the backside of the absorber layer in contact with the layer. In one embodiment, the absorber layer comprises a tellurium-containing II-VI semiconductor, for example, a p-type CdTe.

One or more specific embodiments of the present invention will be described below. In an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present invention, the articles "a," "an," "the," and "said" are intended to mean that there are one or more of the elements. The terms "comprising," "including," and "having" are intended to be inclusive and mean that there may be additional elements other than the listed elements. Moreover, the use of "top," "bottom," "above," "below," and variations of these terms is made for convenience, but does not require any particular orientation of the components unless otherwise stated. As used herein, the terms "disposed over" or "deposited over" or "disposed between" refers to both secured or disposed directly in contact with and indirectly by having intervening layers therebetween.

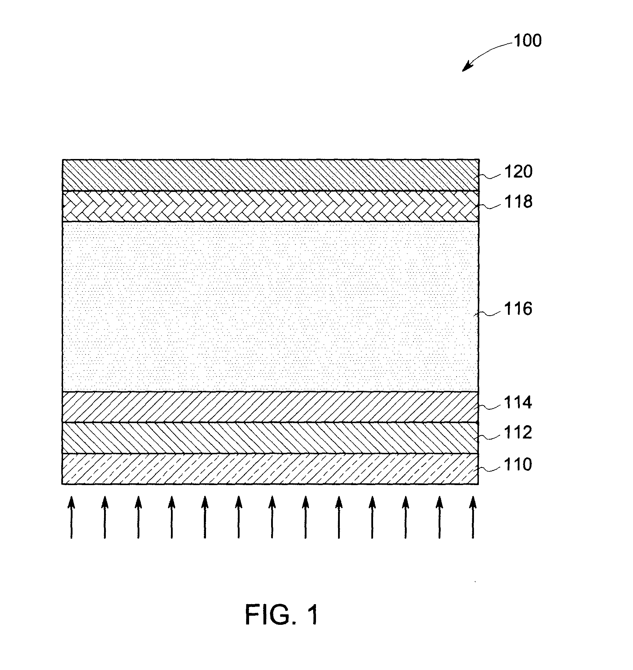

As illustrated in FIG. 1, in one embodiment, a photovoltaic device 100 is provided. The device 100 comprises layers 110, 112, 114, 116, 118, and 120. The layer 116 is an absorber layer, and at least one layer 118 is disposed on the surface of the absorber layer 116. The absorber layer 116 comprises a p+-type semiconductor material, but is substantially free of silicon, meaning that it may contain up to about 50 parts per million to about 100 parts per million of silicon as an incidental impurity. Layer 118 comprises silicon and is a semiconductor having a higher carrier density than the carrier density of the absorber layer 116. In some embodiments, the band gap of layer 118 is larger than the band gap of the absorber layer 116. In some embodiments, the electron affinity of layer 118 is less than or equal to the affinity of the absorber layer 116. Also, in some embodiments, the work function of the layer 118 is greater than or equal to the work function of the absorber layer 116. As discussed above, in some embodiments, the band gap of the layer 118 may be larger or equal to the band gap of the absorber layer 116 to minimize optical absorption occurs in the layer 118. Absorption in this layer 118 is not desirable as it may lead to leakage currents, which will lower the efficiency of the device 100. In some embodiments, the electron affinity of the layer 118 may be lower than or equal to the electron affinity of the absorber layer 116 to provide a barrier for electrons on the backside of the device, acting as a backside surface field which reduces the electron-hole recombination at the cell's back surface and thereby increases the cell's efficiency. In still other embodiments, the work function of the layer 118 may be larger or equal to the work function of the absorber layer 116 to minimize any barrier for the holes, as they are collected at the backside of the absorber layer 116 in contact with the layer 118.

In one embodiment, for example, the photovoltaic device comprises a substrate 110, a front contact layer 112, a buffer layer or a window layer 114, the absorber layer 116, the p+-layer 118, and a back contact layer 120. The light enters from the substrate 110 and after passing through the front contact layer 112 and buffer layer 114, enters the absorber layer. As used herein the term "p+-layer" refers to a p-type semiconductor in which there is an excess mobile hole concentration compared to the absorber layer 116. The p+-layer 118 assists in improving the electrical contact of the absorber layer 116 with the back contact layer 120. In certain embodiments, it will be appreciated by a person skilled in the art that other intermediate layers may be used between the various layers discussed herein. In various embodiments, an antireflective-coating may be applied on top of the substrate 110, a highly resistive transparent conductive oxide layer may be used between the front contact layer 112 and the window layer 114, and this highly resistive layer may function as an additional buffer layer, etc. In one embodiment, the substrate 110 could be applied below the back contact layer 120. The various layers described herein, i.e., the absorber layer 116, the front contact layer 112, the window layer 114, and the back contact layer 120, have functions as commonly known for these layers when used in a photovoltaic device known to one skilled in the art.

Typically, when light falls on the solar cell 100, electrons in the absorber layer 116 are excited from a lower energy "ground state," in which they are bound to specific atoms in the solid, to a higher "excited state," in which they can move through the solid. Since most of the energy in sunlight and artificial light is in the visible range of electromagnetic radiation, a solar cell absorber should be efficient in absorbing radiation at those wavelengths. In one embodiment, the absorber layer 116 comprises a p-type semiconductor. In one embodiment, the absorber layer 116 has a band gap in a range from about 1.3 electron Volts to about 1.6 electron Volts. In another embodiment, the absorber layer 116 has a band gap in a range from about 1.35 electron Volts to about 1.55 electron Volts. In yet another embodiment, the absorber layer 116 has a band gap in a range from about 1.4 electron Volts to about 1.5 electron Volts. In one embodiment, the absorber layer 116 is selected such that the band gap of the layer 118 may be larger or equal to the band gap of the absorber layer 116.

In one embodiment, the absorber layer 116 has an electron affinity in a range from about 3.9 electron Volts to about 4.5 electron Volts. In another embodiment, the absorber layer 116 has an electron affinity in a range from about 4.0 electron Volts to about 4.4 electron Volts. In yet another embodiment, the absorber layer 116 has an electron affinity in a range from about 4.1 electron Volts to about 4.3 electron Volts. In one embodiment, the absorber layer 116 is selected such that the electron affinity of the layer 118 may be lower than or equal to the electron affinity of the absorber layer 116.

In one embodiment, the absorber layer 116 has a work function in a range from about 5.1 electron Volts to about 5.9 electron Volts. In another embodiment, the absorber layer 116 has a work function in a range from about 5.2 electron Volts to about 5.8 electron Volts. In yet another embodiment, the absorber layer 116 has a work function in a range from about 5.5 electron Volts to about 5.7 electron Volts. In one embodiment, the absorber layer 116 is selected such that the work function of the layer 118 may be larger or equal to the work function of the absorber layer 116.

In one embodiment, the absorber layer 116 comprises a tellurium-containing II-VI semiconductor that is substantially free of silicon. In one embodiment, the absorber layer 116 is selected from the group consisting of cadmium telluride, cadmium zinc telluride, tellurium-rich cadmium telluride (i.e., cadmium telluride where the tellurium to cadmium ratio is greater than 1), cadmium sulfur telluride, cadmium manganese telluride, and cadmium magnesium telluride. In one embodiment, the absorber layer 116 comprises cadmium telluride. In another embodiment, the absorber layer 116 comprises p-type cadmium telluride.

In one embodiment, the layer 118 comprises a p+-type semiconductor. In one embodiment, the layer 118 has a band gap in a range from about 1.4 electron Volts to about 2.1 electron volts. In another embodiment, the layer 118 has a band gap in a range from about 1.5 electron Volts to about 2.0 electron Volts. In yet another embodiment, the layer 118 has a band gap in a range from about 1.8 electron Volts to about 1.9 electron Volts. As mentioned above, in one embodiment, the layer 118 is selected such that the band gap of the layer 118 may be larger or equal to the band gap of the absorber layer 116.

In one embodiment, the layer 118 has an electron affinity in a range from about 3.8 electron Volts to about 4.3 electron Volts. In another embodiment, the layer 118 has an electron affinity in a range from about 3.9 electron Volts to about 4.2 electron Volts. In yet another embodiment, the layer 118 has an electron affinity in a range from about 4.0 electron Volts to about 4.1 electron Volts. As mentioned above, in one embodiment, the layer 118 is selected such that the electron affinity of the layer 118 may be lower than or equal to the electron affinity of the absorber layer 116.

In one embodiment, the layer 118 has a work function in a range from about 5.3 electron Volts to about 6.0 electron Volts. In another embodiment, the layer 118 has a work function in a range from about 5.4 electron Volts to about 5.9 electron Volts. In yet another embodiment, the layer 118 has a work function in a range from about 5.6 electron Volts to about 5.8 electron Volts. As mentioned above, in one embodiment, the layer 116 is selected such that the work function of the layer 118 may be larger or equal to the work function of the absorber layer 116.

In one embodiment, the layer 118 comprises hydrogenated amorphous silicon (a-Si:H), hydrogenated amorphous silicon carbon (a-SiC:H), crystalline silicon (c-Si), hydrogenated microcrystalline silicon (mc-Si:H), hydrogenated amorphous silicon germanium (a-SiGe:H), hydrogenated microcrystalline amorphous silicon germanium (mc a-SiGe:H), gallium arsenide (GaAs), or a combination thereof. In one embodiment, the layer 118 comprises a-Si:H or a-SiC:H. This layer can be grown using radio frequency plasma enhanced chemical vapor deposition technique (RF-PECVD). The layer 118 is made with a desirably high carrier concentration by adding either diborane or trimethyl borane (TMB) to the plasma in order to dope the layer with boron. The band gap of the layers may be modified, by adjusting the concentration of boron, germanium, carbon, and/or hydrogen within the layers. One skilled in the art will appreciate the various methods by which such compositional adjustments are generally made.

In one embodiment, the absorber layer 116 is a p-type semiconductor and the layer 118 is a p+-type semiconductor. In one embodiment, the carrier density of the p-type carriers, i.e., the holes in the absorber layer 116 is in a range from about 1 x 10¹⁴ per cubic centimeter to about 5 x 10¹⁶ per cubic centimeter. In another embodiment, the carrier density of the absorber layer 116 is in a range from about 2 x 10¹⁴ per cubic centimeter to about 3 x 10¹⁶ per cubic centimeter. In yet another embodiment, the carrier density of the absorber layer 116 is in a range from about 3 x 10¹⁴ per cubic centimeter to about 1 x 10¹⁶ per cubic centimeter.

In one embodiment, the carrier density of the p-type carriers, i.e., the holes in the layer 118, is at least about 1 x 10¹⁷ per cubic centimeter. In certain embodiments, the carrier density of the layer 118 is at least about 5 x 10¹⁷ per cubic centimeter. In particular embodiments, the carrier density of the at least one layer 118 is at least about 1 x 10¹⁸ per cubic centimeter.

In various embodiments, the substrate 110, the front contact layer 112, the window layer 114, and the back contact layer 120 may be employed to form the photovoltaic device; suitable materials and methods for depositing such materials are well appreciated in the art. In one embodiment, the front contact layer 112 comprises a transparent conductive oxide selected from the group consisting of cadmium tin oxide, zinc tin oxide, indium tin oxide, aluminum-doped zinc oxide, zinc oxide, and/or fluorine-doped tin oxide, and combinations thereof. In one embodiment, the substrate 110 comprises glass or polymer. In one embodiment, the window layer 114 comprises Cadmium Sulfide (CdS), Zinc Telluride (ZnTe), Zinc Selenide (ZnSe), Cadmium Selenide (CdSe), Zinc Sulfide (ZnS), Indium Selenide (In₂Se₃), Indium Sulfide (In₂S₃), Zinc oxihydrate (Zn(OH)) and combinations thereof. In one embodiment, the back contact layer comprises one or more metals selected from molybdenum, aluminum, chromium, and nickel. In certain embodiments, another metal layer for example, aluminum, is disposed on the back contact layer to provide lateral conduction to the outside circuit.

Another embodiment is a photovoltaic device 100. The device comprises an absorber layer 116, wherein the absorber layer 116 comprises a tellurium-containing II-VI semiconductor. The layer 118 is disposed over the absorber layer 116. The at least one layer 118 is a p+-type semiconductor, comprising silicon. The band gap, work function, electron affinity, and charge density of the absorber layer 116 and the layer 118 may be selected from the range of values described above.

Another embodiment is a photovoltaic device 100. The device comprises an absorber layer 116, wherein the absorber layer 116 comprises a p-type tellurium-containing II-VI semiconductor that is substantially free of silicon. The layer 118 is disposed over the absorber layer 116. The layer 118 is a p+-type semiconductor comprising silicon. The band gap, work function, electron affinity, and charge density of the absorber layer 116 and the layer 118 may be selected from the range of values described above. The photovoltaic device also includes a substrate 110, a front contact layer 112, a window layer 114, and a back contact layer 120 as described above.

Yet another embodiment is a photovoltaic device 100. The device comprises an absorber layer 116, wherein the absorber layer comprises a p-type cadmium telluride. Layer 118 is disposed over the absorber layer 116, wherein the layer 118 comprises a p+-type hydrogenated amorphous silicon. The photovoltaic device also includes a substrate 110, a front contact layer 112, a window layer 114, and a back contact layer 120 as described above.

Yet another embodiment is a photovoltaic device 100. The device comprises an absorber layer 116, wherein the absorber layer comprises a p-type cadmium telluride. Layer 118 is disposed over the absorber layer, wherein the layer 118 comprises a p+-type hydrogenated amorphous silicon carbon. The photovoltaic device also includes a substrate 110, a front contact layer 112, a window layer 114, and a back contact layer 120 as described above.

Still yet another embodiment is a method. The method comprises a first step of providing an absorber layer 116 comprising a p-type semiconductor, in a photovoltaic device. The layer 118 is disposed over the absorber layer. The layer 118 comprises p+-type semiconductor. The absorber layer is substantially free of silicon. The absorber layer 116 is treated as discussed below to increase its carrier density compared to the as-deposited state of the film. Further, the absorber layer is processed to provide a stoichiometric absorber layer, which means that the cadmium-to-tellurium ratio at the interface is substantially the same as in the bulk, i.e., the ratio is about 1. Layer 118 has the characteristics as described for the devices above. In one embodiment, the layers may be deposited by employing one or more methods selected from close-space sublimation (CSS), vapor transport method (VTM), ion-assisted physical vapor deposition (IAPVD), radio frequency or pulsed magnetron sputtering (RFS or PMS), plasma enhanced chemical vapor deposition (PECVD), and electrochemical bath deposition (CBD).

In one embodiment, a method is provided for forming an n-p-p+ device. In this method a front contact layer 112 is deposited on a substrate 110 as shown in the FIG. 1. An n-type window or buffer layer 114, as shown in FIG 1, is then deposited over the front contact layer 112. The deposition of the window layer 114 or the front contact layer 112 may be achieved by methods known to one skilled in the art. Non-limiting examples of the deposition methods include one or more of CSS, VTM, and CBD.

An absorber layer 116 is then deposited over the n-type window layer 114. The absorber layer 116 may also be deposited by employing methods known to one skilled in the art. Non-limiting examples of the deposition methods include one or more of electrochemical deposition (ECD), CSS and VTM. In one embodiment, when the absorber layer is a p-type cadmium telluride layer, the absorber layer 116 is treated with cadmium chloride. In one embodiment, the absorber layer 116 may be treated with a solution of CdC1₂ salt. In another embodiment, the absorber layer 116 may be treated with CdC1₂ vapor. The treatment with CdC1₂ is known to increase the carrier density of the absorber layer. The treatment with cadmium chloride is followed by an etching step. In one embodiment, the etch may be carried out by using hydrochloric acid. The etching results in a stoichiometric cadmium telluride at the interface, mainly removing the cadmium oxide from the surface, leaving a cadmium-to-tellurium ratio of about 1 at the surface. The etching works by removing non-stoichiometric material that forms at the surface during processing. Other etching techniques known in the art that may result in a stoichiometric cadmium telluride at the interface may also be employed.

A p+-type layer 118 is then deposited over the stoichiometric absorber layer 116. The deposition of the p+-type layer 118 is achieved by depositing, for example, p-type a-SiGe:H, a-Si:H, or a-SiC:H on the absorber layer 116 using a technique as known to one skilled in the art, such as a PECVD technique as described below. In one embodiment, the exact layer composition may be determined by the valence band maximum of the absorber layer 116 that the p+ layer 118 is applied on. In a first step, to make the layer 118, germane (GeH₄), silane (SiH₄), and/or methane (CH₄) may be intermixed in a required proportion in the plasma. The plasma could further include argon and hydrogen. These techniques are known in the art. Further, to render the layer 118 p+-type, diborane (B₂H₆), or trimethyl borane (TMB) are intermixed with the plasma containing at least one silicon precursor. Controlling the concentration of boron, germanium, hydrogen and carbon in the film may assist in modifying the band gap, the electron affinity, and the work function to the levels that render the p-type a-Si:H layer or p-type a-SiC:H layer as a p+-type layer 118. Finally, the device is completed by depositing a back contact layer, for example a metal layer.

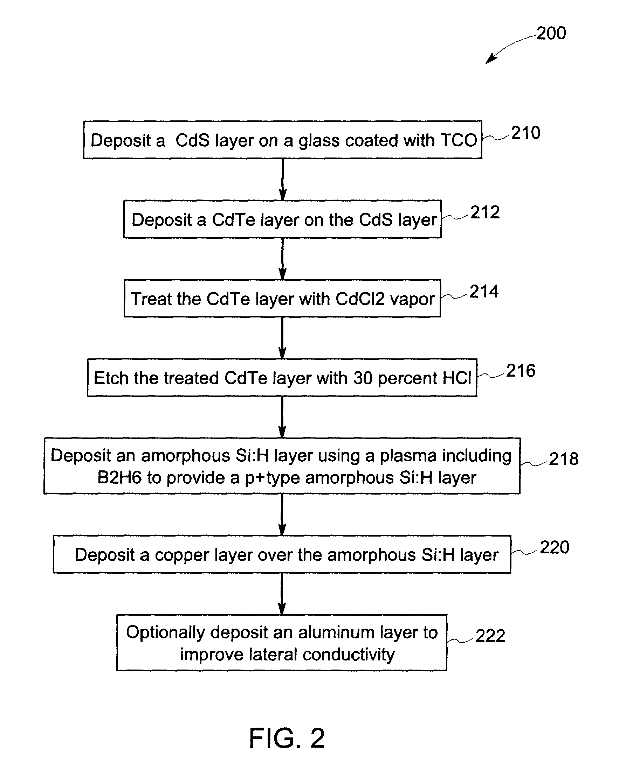

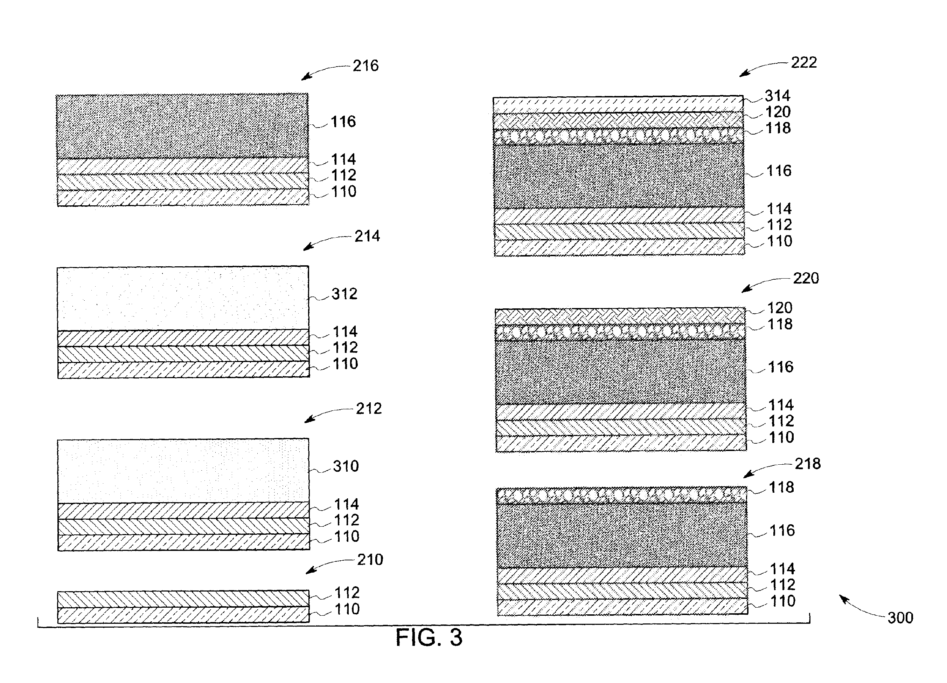

Referring to FIG. 2 and FIG. 3, an exemplary, non-limiting method 200 of forming an n-p-p+ device 222 is provided. In a first step 210 a CdS layer 114 is deposited on glass 110 that is coated with a transparent conductive oxide 112. The CdS layer 114 is coated using the CSS technique. In a second step 212 a CdTe layer 310 having a thickness of about 3 microns to about 5 microns is deposited on the top of the CdS layer 114 using a CSS technique. In a third step 214 the CdTe layer 310 is exposed to a CdC1₂ treatment to provide a CdTe layer 312 with higher carrier density. In a fourth step 216, the CdC1₂ treated CdTe layer 312 is etched using 30 percent concentrate hydrochloric acid to provide a stoichiometric CdTe layer 116. In a fifth step 218, a p+ layer a-Si:H 118 is deposited over the CdTe layer 116 using a PECVD technique where the plasma containing the a-Si:H is intermixed with B₂H₆ to control the boron and carbon concentration in the p+-type layer 118. In the sixth step 220, a metal layer is deposited on the surface of the p+-type layer 118 to form the back contact layer. Optionally, in a seventh step 222, the metal layer could be topped with 100 nanometers of an aluminum layer 314 to improve lateral conductivity.

Referring to FIG. 2 and FIG. 3, in another embodiment, is provided a method 300 to form an n-i-p+ device 222. The method is similar to that discussed above for forming the n-p-p+ device except in that the time of the etch or the amount of the CdTe layer 312 etched is such that less than 2 micron of CdTe is left behind to form the absorber layer 116. The thickness of the CdTe layer left behind is such that the grain-boundaries are not opened, i.e., no pinholes are formed in the CdTe layer. Typically, during etching, the grain boundaries will etch faster than the grains, resulting in pinholes in the CdTe layer, for example, formation of pinholes at grain boundaries near the surface of the CdTe layer, if proper thickness control is not maintained.

Referring to FIG. 2 and FIG. 3, in yet another embodiment, is provided a method to form an n-i-p+ device 222. The method is similar to that discussed above for forming the n-p-p+ device except in that the initial thickness of the CdTe layer 310 as deposited is less than 1-2 micrometers and the time of the CdC1₂ treatment is made significantly shorter as the required carrier density is achieved and the carrier density does not need to be optimized. Also the etching of the resultant CdTe layer 312 to form the CdTe layer 116 is done such that the etch does not attack the grain boundaries. This may be done by using an aggressive etch, such as HCI (meaning it attacks the material in a uniform manner rather than being selective to the grain boundaries) or by using a solution that is sufficiently viscous such that it does not penetrate into the grain boundaries of the CdTe layer 312.

In one embodiment, the photovoltaic device is a photovoltaic cell or a photovoltaic module. The photovoltaic device 100 produced as discussed typically requires further features to be used for practical electricity generation. That is, a terminal may be formed through which the generated electric power is led and a means for consuming or storing it. Alternatively, since a single power-generating cell usually has a low generated voltage, it may be desirable to form terminals for making voltage higher by connecting the photovoltaic devices in series. Accordingly, an insulating layer is provided to ensure insulation between the substrate and the photovoltaic device 100. Then a terminal made of, for example, a thick foil of a metal is connected to the back contact layer 120 of the photovoltaic device 100 using a conductive adhesive or other suitable connection means so that it can be used as a power-withdrawing terminal or a terminal for connecting in series another adjoining photovoltaic device constituted similarly. Thus, in one embodiment, a solar panel, i.e., a photovoltaic module comprising a plurality of photovoltaic devices as described above may be assembled in series to form a photovoltaic module.

While only certain features of the invention have been illustrated and described herein, many modifications and changes will occur to those skilled in the art. It is, therefore, to be understood that the appended claims are intended to cover all such modifications and changes as fall within the true spirit of the invention.

Various aspects and embodiments of the present invention are defined by the following numbered clauses:
1. A photovoltaic device, comprising:
   an absorber layer comprising a p-type semiconductor, wherein at least one layer is disposed over the absorber layer;
   wherein the at least one layer is a semiconductor having a higher carrier density than the carrier density of the absorber layer, wherein the at least one layer comprises silicon;
   wherein the at least one layer comprises a p+-type semiconductor.
   wherein the absorber layer is substantially free of silicon.
2. The photovoltaic device as defined in clause 1, wherein the at least one layer has a band gap that is larger than the band gap of the absorber layer.
3. The photovoltaic device as defined in any preceding clause, wherein the at least one layer has an electron affinity which is lower than the electron affinity of the absorber layer.
4. The photovoltaic device as defined in any preceding clause, wherein the at least one layer has a work function which is larger than or equal to the work function of the absorber layer.
5. The photovoltaic device as defined in any preceding clause, wherein the absorber layer has a band gap in a range from about 1.3 electron Volts to about 1.6 electron Volts.
6. The photovoltaic device as defined in any preceding clause, wherein the absorber layer has an electron affinity in a range from about 3.9 electron Volts to about 4.5 electron Volts.
7. The photovoltaic device as defined in any preceding clause, wherein the absorber layer has a work function in a range from about 5.1 electron Volts to about 5.9 electron Volts.
8. The photovoltaic device as defined in any preceding clause, wherein the absorber layer comprises cadmium telluride, cadmium zinc telluride, tellurium-rich cadmium telluride, cadmium sulfur telluride, cadmium manganese telluride, or cadmium magnesium telluride.
9. The photovoltaic device as defined in any preceding clause, wherein the at least one layer has a band gap in a range from about 1.4 electron Volts to about 2.1 electron Volts.
10. The photovoltaic device as defined in any preceding clause, wherein the at least one layer has an electron affinity in a range from about 3.8 electron Volts to about 4.3 electron Volts.
11. The photovoltaic device as defined in any preceding clause, wherein the at least one layer has a work function in a range from about 5.3 electron Volts to about 6.0 electron Volts.
12. The photovoltaic device as defined in any preceding clause, wherein the absorber layer has a carrier density in a range from about 1 x 10¹⁴ per cubic centimeter to about 5 x 10¹⁶ per cubic centimeter.
13. The photovoltaic device as defined in any preceding clause, wherein the at least one layer has a carrier density of at least about 1 x 10¹⁷ per cubic centimeter.
14. The photovoltaic device as defined in any preceding clause, wherein the at least one layer comprises hydrogenated amorphous silicon, hydrogenated amorphous silicon carbon, crystalline silicon, hydrogenated microcrystalline silicon, hydrogenated amorphous silicon germanium, hydrogenated microcrystalline amorphous silicon germanium, gallium arsenide, or a combination thereof.
15. A photovoltaic device, comprising:
   an absorber layer, wherein the absorber layer comprises a tellurium-containing II-VI semiconductor;
   wherein at least one layer is disposed over the absorber layer;
   wherein the at least one layer is a p+-type semiconductor, comprising silicon.
16. The photovoltaic device as defined in any preceding clause, wherein the absorber layer has a carrier density in a range from about 1 x 10¹⁴ per cubic centimeter to about 5 x 10¹⁶ per cubic centimeter.
17. The photovoltaic device as defined in any preceding clause, wherein the at least one layer has a carrier density of at least about 1 x 10¹⁷ per cubic centimeter to about 1 x 10²⁰ per cubic centimeter.
18. A photovoltaic device, comprising:
   an absorber layer, wherein the absorber layer comprises a p-type tellurium-containing 11-VI semiconductor;
   wherein at least one layer is disposed over the absorber layer;
   wherein the at least one layer is a p+-type semiconductor, comprising silicon.
19. A photovoltaic device, comprising:
   an absorber layer, wherein the absorber layer comprises a p-type cadmium telluride; and
   at least one layer is disposed over the absorber layer, wherein the at least one layer comprises a p+-type hydrogenated amorphous silicon.
20. A photovoltaic device, comprising:
   an absorber layer, wherein the absorber layer comprises a p-type cadmium telluride; and
   at least one layer disposed over the absorber layer, wherein the at least one layer comprises a p+-type hydrogenated amorphous silicon carbon.
21. A method comprising:
   providing an absorber layer in a photovoltaic device, wherein the absorber layer is treated to increase its carrier density, wherein the absorber layer is etched to provide a stoichiometric absorber layer, wherein the absorber layer is substantially free of silicon, wherein the absorber layer comprises a p-type semiconductor;
   wherein at least one layer is disposed over the absorber layer, wherein the at least one layer comprises a p+-type semiconductor; and the at least one layer is a semiconductor having a higher carrier density than the carrier density of the absorber layer; and
   wherein the at least one layer comprises silicon.
22. The method as defined in any preceding clause, wherein the at least one layer has a band gap that is larger than the band gap of the absorber layer.
23. The method as defined in any preceding clause, wherein the at least one layer has an electron affinity which is lower than the electron affinity of the absorber layer.
24. The method as defined in any preceding clause, wherein the at least one layer has a work function which is larger than or equal to the work function of the absorber layer.
25. The method as defined in any preceding clause, wherein the layers are deposited using one or more techniques selected from close-space sublimation, vapor transport deposition, ion-assisted physical vapor deposition, radio frequency or pulsed magnetron sputtering, plasma enhanced chemical vapor deposition, and electrochemical bath deposition.
26. A solar panel comprising a plurality of photovoltaic devices as described in any preceding clause.

## Claims

1. A photovoltaic device (100), comprising:
an absorber layer (116) comprising a p-type semiconductor, wherein at least one layer (118) is disposed over the absorber layer (116);
wherein the at least one layer (118) is a semiconductor having a higher carrier density than the carrier density of the absorber layer, wherein the at least one layer comprises silicon;
wherein the at least one layer (118) comprises a p+-type semiconductor.
wherein the absorber layer (116) is substantially free of silicon.

2. The photovoltaic device (100) as defined in claim 1, wherein the at least one layer (118) has a band gap that is larger than the band gap of the absorber layer; wherein the at least one layer has an electron affinity which is lower than the electron affinity of the absorber layer; and wherein the at least one layer has a work function which is larger than or equal to the work function of the absorber layer(116).

3. The photovoltaic device (100) as defined in any preceding claim, wherein the absorber layer (116) has a band gap in a range from about 1.3 electron Volts to about 1.6 electron Volts; an electron affinity in a range from about 3.9 electron Volts to about 4.5 electron Volts; and a work function in a range from about 5.1 electron Volts to about 5.9 electron Volts.

4. The photovoltaic device (100) as defined in any preceding claim, wherein the at least one layer (118) has a band gap in a range from about 1.4 electron Volts to about 2.1 electron Volts; an electron affinity in a range from about 3.8 electron Volts to about 4.3 electron Volts; and a work function in a range from about 5.3 electron Volts to about 6.0 electron Volts.

5. The photovoltaic device (100) as defined in any preceding claim, wherein the absorber layer (116) has a carrier density in a range from about 1 x 10¹⁴ per cubic centimeter to about 5 x 10¹⁶ per cubic centimeter and the at least one layer has a carrier density of at least about 1 x 10¹⁷ per cubic centimeter.

6. A photovoltaic device (100), comprising:
an absorber layer (116), wherein the absorber layer comprises a tellurium-containing II-VI semiconductor;
wherein at least one layer (118) is disposed over the absorber layer;
wherein the at least one layer (118) is a p+-type semiconductor, comprising silicon.

7. A photovoltaic device (100), comprising:
an absorber layer (116), wherein the absorber layer comprises a p-type tellurium-containing II-VI semiconductor;
wherein at least one layer (118) is disposed over the absorber layer;
wherein the at least one layer is a p+-type semiconductor, comprising silicon.

8. A photovoltaic device (100), comprising:
an absorber layer (116), wherein the absorber layer comprises a p-type cadmium telluride; and
at least one layer is disposed over the absorber layer, wherein the at least one layer comprises a p+-type hydrogenated amorphous silicon.

9. A photovoltaic device (100), comprising:
an absorber layer (116), wherein the absorber layer comprises a p-type cadmium telluride; and
at least one layer (118) disposed over the absorber layer, wherein the at least one layer comprises a p+-type hydrogenated amorphous silicon carbon.

10. A method (200) comprising:
providing an absorber layer (116) in a photovoltaic device (100), wherein the absorber layer is treated to increase its carrier density, wherein the absorber layer is etched to provide a stoichiometric absorber layer, wherein the absorber layer is substantially free of silicon, wherein the absorber layer comprises a p-type semiconductor;
wherein at least one layer (118) is disposed over the absorber layer (116), wherein the at least one layer comprises a p+-type semiconductor; and the at least one layer is a semiconductor having a higher carrier density than the carrier density of the absorber layer; and
wherein the at least one layer (118) comprises silicon.
